# EUROPEAN PATENT APPLICATION

(11) **EP 2 093 803 A1**
(43) Date of publication of application: **26.08.2009**
(21) Application number: 07832399.5
(22) Date of filing: 22.11.2007
(51) Int. Cl.: H01L 31/04

(54) **SOLAR CELL MODULE AND SOLAR CELL MODULE MANUFACTURING METHOD**

(30) Priority: 30.11.2006 JP 2006324599
(71) Applicant: Sanyo Electric Co., Ltd., Osaka 570-8677 (JP)
(72) Inventor: YATA, Shigeo, Moriguchi City Osaka 570-8677 (JP)
(74) Representative: Calderbank, Thomas Roger
(86) International application number: PCT/JP2007/072670
(87) International publication number: WO 2008/065970

(57) **Abstract**

Provided are a solar cell module and a solar cell module manufacturing method, the solar cell module being capable of maintaining a higher power generation capacity even if water infiltrates. In a solar cell module 10, in a first groove section 30, a second transparent conductive film 14a is in contact with a first transparent conductive film 12 while covering a side wall of a photoelectric conversion layer 13. A metal film 14b is in contact with the first transparent conductive film 12 while covering a side wall of the second transparent conductive film 14a. In the first groove section 30, the metal film 14b is in contact with the photoelectric conversion layer 13 while covering a side wall of the second transparent conductive film 14a formed on the photoelectric conversion layer 13.

## Description

### Technical Field

The present invention relates to a solar cell module and a solar cell module manufacturing method, the solar cell module including a first electrode stacked on a transparent substrate, a photoelectric conversion layer stacked on the first electrode, and a second electrode stacked on the photoelectric conversion layer, the second electrode formed of a transparent conductive film and a metal film.

### Background Art

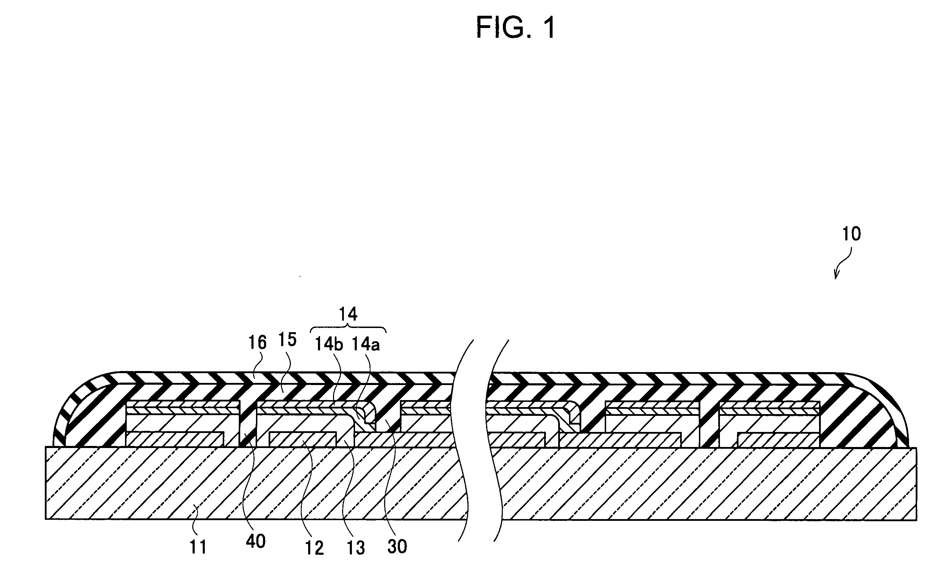

In recent years, thin film solar cell modules using a less amount of raw materials have been vigorously developed in order to achieve cost reduction and higher efficiency of solar cells at the same time. An example of a cross-sectional view of a conventional thin film solar cell module is shown in Fig. 1.

As shown in Fig. 1, a conventional thin film solar cell module 10 is formed by sequentially stacking a first transparent conductive film 12, a photoelectric conversion layer 13, and a back surface electrode 14 on a transparent substrate 11 such as glass while they are patterned by laser irradiation. In addition, in the solar cell module 10, a protecting member 16 of polyethylene terephthalate (PET) or the like is disposed on the back surface electrode 14 with a bonding layer 15 of ethylene vinyl acetate (EVA) or the like interposed therebetween.

Here, there has been proposed an approach to form the back surface electrode 14 by stacking a metal thin film 14b on a second transparent conductive film 14a (see Patent Document 1, for example). According to this approach, it is possible to easily pattern the back surface electrode 14 by laser irradiation by making effective use of the laser ablation phenomenon in the second transparent conductive film 14a, which occurs at the time of patterning the back surface electrode 14 by the laser irradiation. In short, the back surface electrode 14 is patterned by applying the laser simultaneously on the second transparent conductive film 14a and the metallic thin film 14b.
Patent Document 1: JP-A 8-56004

### Disclosure of the Invention

In general, the solar cell module 10 is used outdoors for a long time. For this reason, the solar cell module 10 is required to possess moisture resistance sufficient to maintain a stable and high power generation capacity even if moisture infiltrates the inside of the solar cell module 10.

However, in the solar cell module 10, portions of the second transparent conductive film 14a are not covered with the metal thin film 14b and thus exposed, as shown in Fig. 1. Therefore, the second transparent conductive film 14a is easily deteriorated if moisture having infiltrated the protecting member 16 and the bonding layer 15 reaches the second transparent conductive film 14a. As a result, there is a problem that the solar cell module 10 cannot maintain the stable and high power generation capacity.

The present invention has been made in view of the above-mentioned problem and an object thereof is to provide a solar cell module and a solar cell manufacturing method, the solar cell module capable of maintaining a high power generation capacity even if moisture infiltrates.

A solar cell module according to a first aspect of the present invention provides a solar cell module comprises: a transparent substrate; a first electrode stacked on the transparent substrate; a photoelectric conversion layer stacked on the first electrode; a second electrode stacked on the photoelectric conversion layer; and a groove section in which the second electrode is separated, wherein the second electrode includes a transparent conductive film stacked on the photoelectric conversion layer and a metal film stacked on the transparent conductive film, and, in the groove section, the metal film is separated by a distance of a width smaller than a width that is a distance by which to separate the transparent conductive film.

According to the solar cell module of the first aspect, the transparent conductive film is covered with the metal film and thus is not exposed. Therefore, the transparent conductive film sealed by the metal film is not deteriorated by moisture even if the infiltrating moisture reaches a back surface electrode, and thus it is possible to maintain a stable and high power generation capacity.

A second aspect of the present invention provides the solar cell module according to the first aspect of the present invention, wherein, in the groove section, the transparent conductive film is in contact with the first electrode while covering a side wall of the photoelectric conversion layer; and in the groove section, the metal film is in contact with the first electrode while covering a side wall of the transparent conductive film.

A third aspect of the present invention provides the solar cell module according to the first aspect of the present invention, wherein, in the groove section, the metal film is in contact with the photoelectric conversion layer while covering a side wall of the transparent conductive film.

A fourth aspect of the present invention provides a method of manufacturing a solar cell module provided with: a transparent substrate; a first electrode stacked on the transparent substrate; a photoelectric conversion layer stacked on the first electrode; a transparent conductive film stacked on the photoelectric conversion layer; a metal film stacked on the transparent conductive film; and a groove section in which each of the photoelectric conversion layer, the transparent conductive film, and the metal film is separated, the method comprising: a step A of removing a portion of the photoelectric conversion layer by irradiating the groove section with a laser beam; a step B of stacking the transparent conductive film on the photoelectric conversion layer; a step C of removing a portion of the transparent conductive film by irradiating the groove section a laser beam; a step D of stacking the metal film on the transparent conductive film; and a step E of removing a portion of the metal film by irradiating the groove section with a laser beam, wherein a width of the portion of the metal film removed in the step E is smaller than a width of the portion of the transparent conductive film removed in the step C.

### Brief Description of the Drawings

[Fig. 1] Fig. 1 is a cross-sectional view showing a configuration of a conventional solar cell module.
[ Fig. 2] Fig. 2 is a top view of a solar cell module according to an embodiment.
[ Fig. 3] Fig. 3 is an enlarged cross-sectional view (No. 1) of the solar cell module according to the embodiment, which is taken along the line A-A of Fig. 2.
[ Fig. 4] Fig. 4 is an enlarged cross-sectional view (No. 2) of the solar cell module according to the embodiment, which is taken along the line B-B of Fig. 2.
[ Fig. 5] Fig. 5 (A) is a view (No. 1) taken along the line A-A of Fig. 2 for explaining a method of manufacturing the solar cell module according to the embodiment. Fig. 5(B) is a view (No. 1) taken along the line B-B of Fig. 2 for explaining the method of manufacturing the solar cell module according to the embodiment.
[ Fig. 6] Fig. 6 (A) is a view (No. 2) taken along the line A-A of Fig. 2 for explaining the method of manufacturing the solar cell module according to the embodiment. Fig. 6(B) is a view (No. 2) taken along the line B-B of Fig. 2 for explaining the method of manufacturing the solar cell module according to the embodiment.
[Fig. 7] Fig. 7 is a view (No. 3) taken along the line A-A of Fig. 2 for explaining the method of manufacturing the solar cell module according to the embodiment.
[ Fig. 8] Fig. 8 (A) is a view (No. 4) taken along the line A-A of Fig. 2 for explaining the method of manufacturing the solar cell module according to the embodiment. Fig. 8(B) is a view (No. 3) taken along the line B-B of Fig. 2 for explaining the method of manufacturing the solar cell module according to the embodiment.
[ Fig. 9] Fig. 9 (A) is a view (No. 5) taken along the line A-A of Fig. 2 for explaining the method of manufacturing the solar cell module according to the embodiment. Fig. 9(B) is a view (No. 4) taken along the line B-B of Fig. 2 for explaining the method of manufacturing the solar cell module according to the embodiment.
[ Fig. 10] Fig. 10 (A) is a view (No. 6) taken along the line A-A of Fig. 2 for explaining the method of manufacturing the solar cell module according to the embodiment. Fig. 10(B) is a view (No. 5) taken along the line B-B of Fig. 2 for explaining the method of manufacturing the solar cell module according to the embodiment.

### Best Modes for Carrying Out the Invention

Next, embodiments of the present invention will be described by using the drawings. In the following description of the drawings, identical or similar constituents are designated by identical or similar reference numerals. However, it is to be noted that the drawings are merely schematic and proportions of dimensions and other factors are different from actuality. Therefore, concrete dimensions and other factors should be determined in consideration of the following description. Moreover, it is needless to say that the drawings contain portions having dimensional relations and proportions which are different among the drawings.

### <Configuration of solar cell module 10>

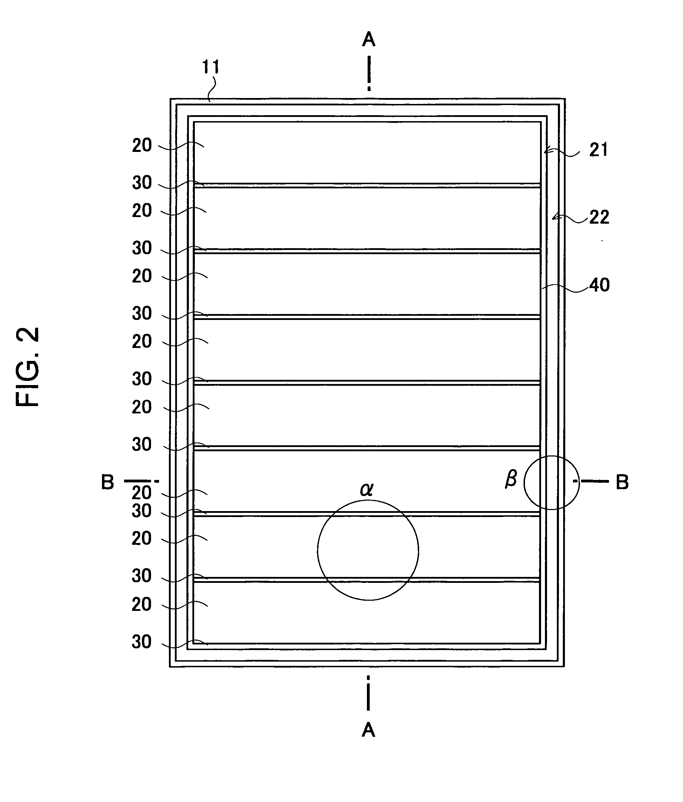

Fig. 2 shows a top view of a solar cell module 10 according to the embodiment of the present invention.

On a transparent substrate 11, the solar cell module 10 includes a power-generating region 21 including multiple photovoltaic devices 20, a non-power-generating region 22 provided around the power-generating region 21, first groove sections 30, and a second groove section 40.

The transparent substrate 11 is a single substrate of the solar cell module 10. The transparent substrate 11 is made of a member, such as a glass, having a light transmitting property and a water blocking property.

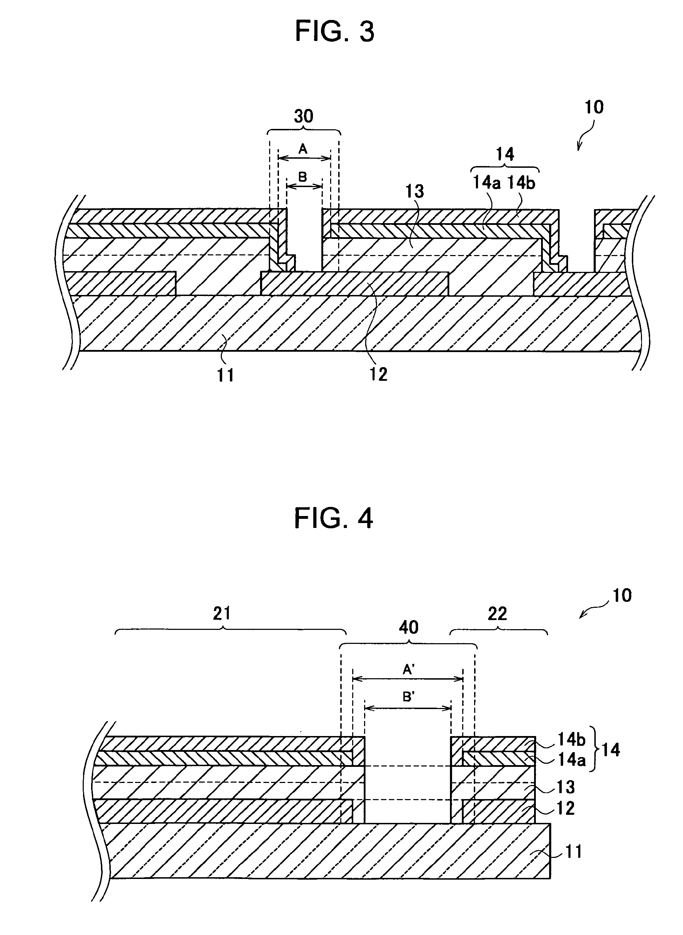

The photovoltaic devices 20 are formed by sequentially stacking a first transparent conductive film 12, a photoelectric conversion layer 13, and a back surface electrode 14 (see Fig 3). The first transparent conductive film 12 of each photovoltaic device 20 is connected to the back surface electrode 14 of another adjacent photovoltaic device 20 in the corresponding first groove section 30. In this way, the photovoltaic devices 20 are electrically connected in series.

The first groove section 30 is a groove in which the photoelectric conversion layer 13 and the back surface electrode 14 of each photovoltaic device 20 is electrically separated from the photoelectric conversion layer 13 and the back surface electrode 14 of the other adjacent photovoltaic device 20.

The power-generating region 21 is formed by electrically connecting the multiple photovoltaic devices 20 to one another in series. The power-generating region 21 is a region that contributes to power generation.

The non-power-generating region 22 is provided around the power-generating region 21 with the second groove section 40 therebetween. The non-power-generating region 22 is a region that does not contribute to power generation. Similarly to the photovoltaic devices 20, the non-power-generating region 22 is a stacked body which is formed by sequentially stacking the first transparent conductive film 12, the photoelectric conversion layer 13, and the back surface electrode 14.

The second groove section 40 is a groove in which the power-generating region 21 is electrically separated from the non-power-generating region 22.

Fig. 3 is a cross-sectional view taken along the line A-A of Fig. 2, which shows an enlarged view of a lower portion (a portion surrounded by α) of Fig. 2.

As shown in Fig. 3, the solar cell module 10 includes the transparent substrate 11, the first transparent conductive film 12 (a first electrode) stacked on the transparent substrate 11, the photoelectric conversion layer 13 stacked on the first transparent conductive film 12, and the back surface electrode 14 (a second electrode) stacked on the photoelectric conversion layer 13.

The first transparent conductive film 12 is stacked on the transparent substrate 11. By removing portions of the first transparent conductive film 12, the first transparent conductive film 12 is formed in a rectangle shape. The first transparent conductive film 12 is formed of either one type of a metal oxide or a stacked body of multiple types of metal oxides selected from a group of metal oxides of ZnO, In₂O₃, SnO₂, CdO, TiO₂, CdIn₂O₄, Cd₂SnO₄, and Zn₂SnO₄ doped with any of Sn, Sb, F, Al, B, and Ga. Here, having a high light transmitting property, low resistance, and plasticity, and also being inexpensive, ZnO is suitable for a material of the transparent conductive film.

The photoelectric conversion layer 13 is stacked on the first transparent conductive film 12. By removing portions of the photoelectric conversion layer 13 respectively in the first groove sections 30, the photoelectric conversion layer 13 is formed in the rectangle shape. The photoelectric conversion layer 13 is made of an amorphous silicon semiconductor. To be more precise, the photoelectric conversion layer 13 is formed by stacking a microcrystalline silicon semiconductor on an amorphous silicon semiconductor. The amorphous silicon semiconductor and the microcrystalline silicon semiconductor have mutually different optical absorption wavelengths. Accordingly, such a tandem solar cell module can utilize a sunlight spectrum effectively. Note that in this specification, the term "microcrystalline" means one including numerous minute crystal grains and also means a state of containing a partially amorphous state.

The back surface electrode 14 has a two-layer structure obtained by stacking a metal film 14b on a second transparent conductive film 14a.

The second transparent conductive film 14a is stacked on the photoelectric conversion layer 13. By removing portions of the second transparent conductive film 14a in the respective first groove sections 30, the second transparent conductive film is formed in the rectangle shape. As shown in Fig. 3, the width of each of the removed portions of the second transparent conductive film 14a is defined as A.

The metal film 14b is stacked on the second transparent conductive film 14a. By removing portions of the metal film 14b in the respective first groove sections 30, the metal film 14b is formed in the rectangle shape. As shown in Fig. 3, the width of each of the removed portions of the metal film 14b is defined as B.

Here, in the solar cell module 10 according to this embodiment, the width B of the removed portion of the metal film 14b is smaller than the width A of the removed portion of the second transparent conductive film 14a.

In other words, in the first groove section 30, the metal film 14b is separated by a distance of the width B smaller than the width A that is a distance by which to separate the second transparent conductive film 14a.

To be more precise, as shown in Fig. 3, in the first groove section 30, the second transparent conductive film 14a is in contact with the first transparent conductive film 12 while covering a side wall of the photoelectric conversion layer 13. Meanwhile, the metal film 14b is in contact with the first transparent conductive film 12 while covering a side wall of the second transparent conductive films 14a. Moreover, in the first groove section 30, the metal film 14b is in contact with the first transparent conductive film 12 while covering a side wall of the second transparent conductive film 14a formed on the photoelectric conversion layer 13.

In this way, the second transparent conductive film 14a is in a state of being covered with the metal film 14b in the first groove sections 30 and thus is not exposed to the outside.

As similar to the first transparent conductive film 12, the second transparent conductive film 14a is formed of either one type of a metal oxide or a stacked body of multiple types of metal oxides selected from the group of the metal oxides of ZnO, In₂O, SnO₂, CdO, TiO₂, CdIn₂O₄, Cd₂SnO₄, and Zn₂SnO₄ doped with any of Sn, Sb, F, Al, B, and Ga.

The metal film 14b is formed of either a member of one type or a stacked body of multiple types selected from a group of Ag, Al, Ti, Pt, Mo, Ta, and the like.

Fig. 4 is a cross-sectional view taken along the line B-B of Fig. 2, which shows an enlarged view of a right portion (a portion surrounded by β) of Fig. 2.

The second transparent conductive film 14a is stacked on the photoelectric conversion layer 13. A portion of the second transparent conductive film 14a is removed in the second groove section 40. As shown in Fig. 4, the width of the removed portion of the second transparent conductive film 14a is defined as A'.

The metal film 14b is stacked on the second transparent conductive film 14a. A portion of the metal film 14b is removed in the second groove section 40. As shown in Fig. 4, the width of the removed portion of the metal film 14b is defined as B'.

Here, in the solar cell module 10 according to this embodiment, the width B' of the removed portion of the metal film 14b is smaller than the width A' of the removed portion of the second transparent conductive film 14a.

In other words, in the second groove section 40, the metal film 14b is separated by a distance of the width B' smaller than the width A' that is a distance by which to separate the second transparent conductive film 14a.

To be more precise, as shown in Fig. 4, in the second groove section 40, the metal film 14b is in contact with the photoelectric conversion layer 13 while covering a side wall of the second transparent conductive film 14a formed on the photoelectric conversion layer 13.

In this way, the second transparent conductive film 14a is in a state of being covered with the metal film 14b in the second groove section 40 and thus is not exposed to the outside.

### <Method of manufacturing solar cell module 10>

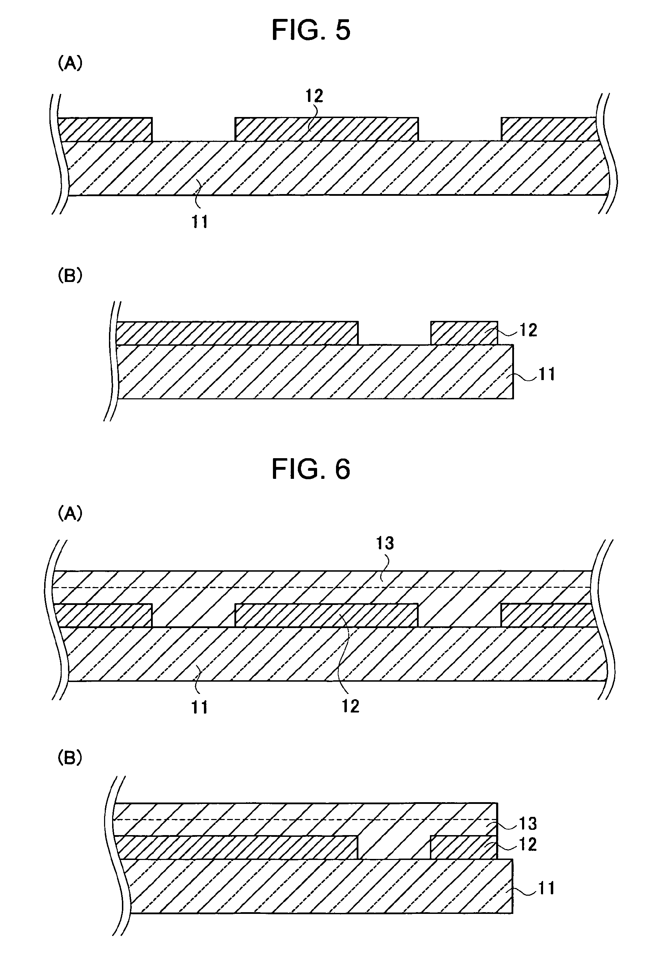

A method of manufacturing the solar cell module 10 according to this embodiment will be described by using Fig. 5 to Fig. 10.

The first transparent conductive film 12 is formed on the transparent substrate 11 by sputtering or the like. As shown in Fig. 5(A), the first transparent conductive film 12 is patterned in the rectangle shapes by YAG laser irradiation. In this way, the first transparent conductive film 12 is electrically separated among the photovoltaic devices 20. Meanwhile, as shown in Fig. 5(B), the first transparent conductive film 12 is subjected to the YAG irradiation by moving the laser back and forth for several times, and thereby being electrically separated into the power-generating region 21 side and the non-power-generating 22 side. That is, a portion of the first transparent conductive film 12 is removed in the second groove section 40. The YAG laser can be applied from a light incident side or from a back surface side opposed from the light incident side.

Next, the photoelectric conversion layer 13 is formed by a plasma CVD method. To be more precise, as shown in Figs. 6 (A) and 6(B), the photoelectric conversion layer 13 is formed by sequentially stacking p-i-n type amorphous silicon semiconductors on the first transparent conductive films 12 and p-i-n type microcrystalline silicon semiconductors thereon.

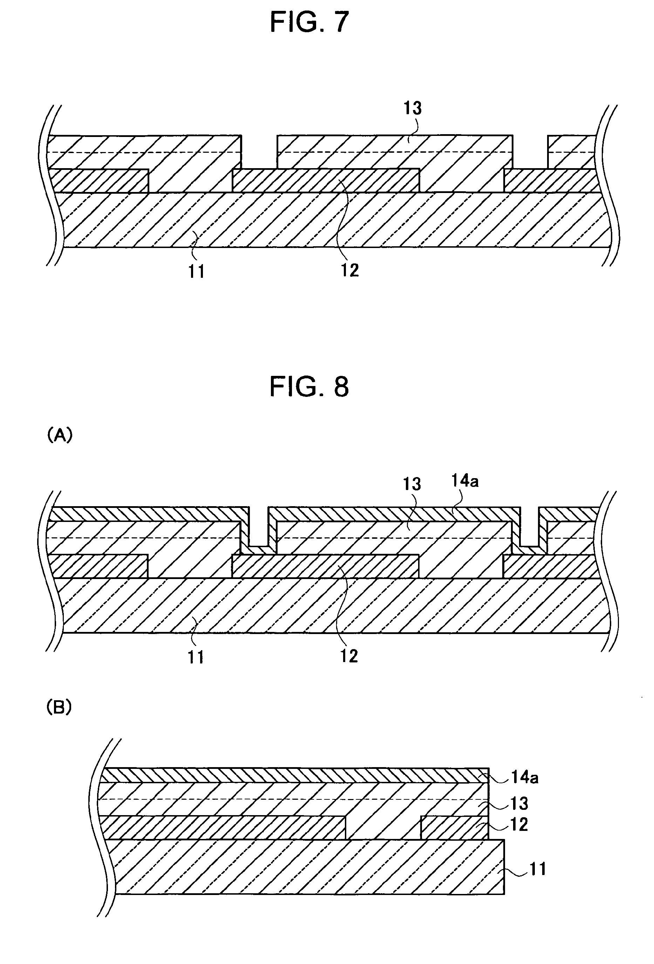

The photoelectric conversion layer 13 is patterned in the rectangle shapes by applying the YAG laser from the light incident side onto positions located at predetermined intervals away from the patterning positions for the first transparent conductive film 12. Specifically, portions of the photoelectric conversion layer 13 are removed in the respective first groove sections 30. In this way, the photoelectric conversion layer 13 is electrically separated for each of the photovoltaic devices 20 as shown in Fig. 7.

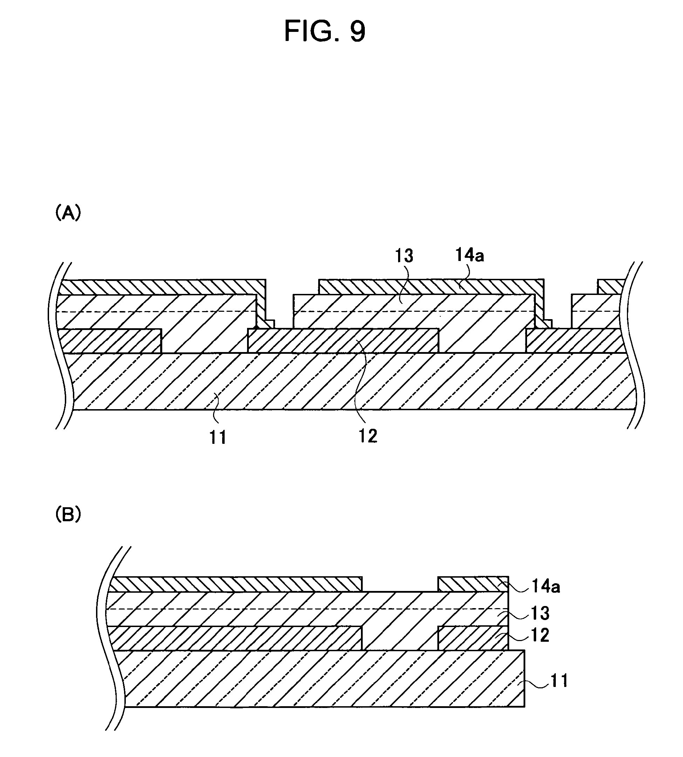

Next, the second transparent conductive film 14a is formed on the separated photoelectric conversion layers 13 by sputtering or the like as shown in Figs. 8(A) and 8(B). The second transparent conductive film 14a is patterned in the rectangle shapes by applying the YAG laser from the back surface side onto positions located at predetermined intervals away from the patterning positions for the photoelectric conversion layer 13. Specifically, portions of the transparent conductive film 14a are removed in the respective first groove sections 30. In this way, the transparent conductive film 14a is electrically separated for each of the photovoltaic devices 20 as shown in Fig. 9(A).

Meanwhile, as shown in Fig. 9(B), the second transparent conductive film 14a is subjected the YAG laser irradiation by moving the laser back and forth for several times, and thereby being electrically separated into the power-generating region 21 side and the non-power-generating 22 side. Specifically, a portion of the second transparent conductive film 14a is removed in the second groove section 40.

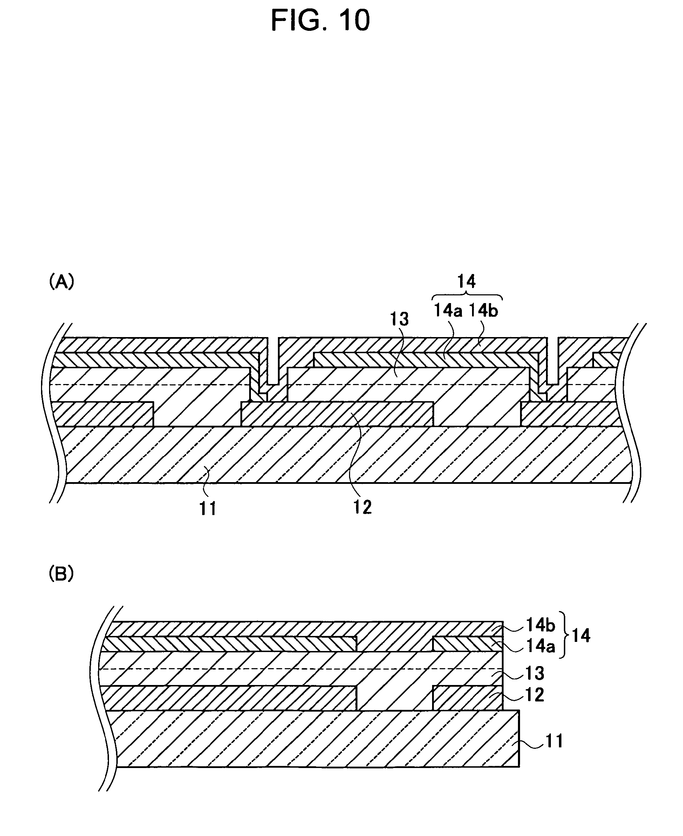

Next, the metal film 14b is formed on the separated second transparent conductive films 14a by sputtering or the like as shown in Figs. 10(A) and 10(B).

Next, as shown in Fig. 3, both of the photoelectric conversion layers 13 and the metal film 14b are patterned in the rectangle shapes by applying the YAG laser from the light incident side onto positions located at predetermined intervals away from the patterning positions for the second transparent conductive film 14a. Specifically, portions of the metal film 14b are removed in the respective first groove sections 30. In particular, in each first groove section 30, the corresponding metal film 14b is removed by a distance of the width B smaller than the width A that is a distance by which to remove the corresponding second transparent conductive film 14a.

Meanwhile, as shown in Fig. 4, each of the photoelectric conversion layer 13 and the metal film 14b is subjected to the YAG laser irradiation from the light incident side and thereby is electrically separated into the power-generating region 21 side and the non-power-generating region 22 side. Specifically, a portion of the metal film 14b is removed in the second groove section 40. In particular, in the second groove section 40, the metal film 14b is removed by a distance of the width B' smaller than the width A' that is a distance by which to remove the second transparent conductive film 14a.

Next, a bonding layer 15 and a protecting member 16 (not shown) each of which is made of a resin are sequentially disposed on the back surface side and vacuum thermo-compression bonding is performed by using a lamination device. Thereafter, the bonding layer 15 is cross-linked and stabilized by a heating treatment.

In addition to EVA, ethylene-based resin such as EEA, PVB, silicone, urethane, acryl, and epoxy resin may be used for the bonding layer 15. Meanwhile, a structure in which a metal foil is sandwiched between a fluorine-containing resin (such as ETFE, PVDF or PCTFE), PC, glass, or the like, SUS, and a steel plate may also be used for the protecting member 16.

Consequently, the solar cell module 10 according to this embodiment is manufactured. Here, it is possible to connect a terminal box and extraction electrodes to the solar cell module 10 and to attach an aluminum frame thereto by using a butyl rubber or the like.

### <Operations and effects>

In the solar cell module 10 according to this embodiment, in the first groove section 30, the second transparent conductive film 14a is in contact with the first transparent conductive film 12 while covering the side wall of the photoelectric conversion layer 13. In the first groove section 30, the metal film 14b is in contact with the first transparent conductive film 12 while covering the side wall of the second transparent conductive film 14a. Moreover, in the first groove section 30, the metal film 14b is in contact with the photoelectric conversion layer 13 while covering the side wall of the second transparent conductive film 14a formed on the photoelectric conversion layer 13.

In this way, the second transparent conductive film 14a is in the state of being covered with the metal film 14b in the first groove section 30 and thus is not exposed to the outside.

Therefore, even if moisture having infiltrated the protecting member 16 and the bonding layer 15 reaches the back surface electrode 14, the second transparent conductive film 14a covered with the metal film 14b is not deteriorated by the moisture. For this reason, the solar cell module 10 can maintain a stable and high power generation capacity.

Such a solar cell module 10 is preferable for the case where ZnO, which is easily deteriorated by moisture, is used as the material of the second transparent conductive film.

### <Other embodiments>

Although the present invention has been described based on the above embodiment, it should not be understood that the statement and the drawings constituting part of this disclosure limit this invention. Various alternative embodiments, examples, and operation techniques become apparent to those skilled in the art from this disclosure.

For example, the above-described embodiment employs the photoelectric conversion layer 13 formed by sequentially stacking the amorphous silicon semiconductor and the microcrystalline silicon semiconductor. However, it is also possible to obtain similar effects by using a single layer made of a microcrystalline or amorphous silicon semiconductor or a stacked body formed by stacking three or more layers of such layer.

Meanwhile, in the above-described embodiment, the patterning by use of the YAG laser is performed after the second transparent conductive film 14a is stacked on the photoelectric conversion layer 13. Alternatively, it is also possible to form the second transparent conductive film 14a by use of a photomask having a desired pattern.

As described above, it is apparent that the present invention includes various embodiments that are not expressly described herein. Therefore, the technical scope of the present invention shall be determined solely by the specified matters in the invention according to the claims that are appropriate from the above description.

### Example

Now, the solar cell module according to the present invention will be concretely described by using an example. It is to be understood that the present invention is not limited to the one shown in the following example and that the present invention can be appropriately modified and embodied as long as the scope thereof is not changed.

### <Example>

The solar cell module 10 shown in Fig. 3 and Fig. 4 was manufactured as described below as the solar cell module according to an example of the present invention.

An SnO₂ electrode 12 having a thickness of 600 nm was formed on a glass substrate 11 having a thickness of 4 mm by the thermal CVD.

Next, the SnO₂ electrode 12 was patterned in the rectangle shape by applying the YAG laser from the light incident side of the glass substrate 11. Nd:YAG laser having a wavelength of about 1.06 µm and energy density of 3×10⁵ W/cm² was used in this laser separation process. Here, a groove having a width of 3 mm was formed at a boundary between the power-generating region 21 and the non-power-generating region 22 by moving the YAG laser back and forth for several times.

Next, the photoelectric conversion layer 13 formed of an amorphous silicon semiconductor layer and a microcrystalline silicon semiconductor layer was formed by the plasma CVD method. To be more precise, the amorphous silicon semiconductor layer was made in accordance with the plasma CVD method by sequentially forming: a p type amorphous silicon semiconductor layer having a film thickness of 10 nm by using a mixed gas of SiH₄, CH₄, H₂, and B₂H₆; an i type amorphous silicon semiconductor layer having a film thickness of 300 nm by using a mixed gas of SiH₄ and H₂; and an n type amorphous silicon semiconductor layer having a film thickness of 20 nm by using a mixed gas of SiH₄, H₂, and PH₃. Meanwhile, the microcrystalline silicon semiconductor layer was made in accordance with the plasma CVD method by sequentially forming: a p type microcrystalline silicon semiconductor layer having a film thickness of 10 nm by using a mixed gas of SiH₄, H₂, and B₂H₆; an i type microcrystalline silicon semiconductor layer having a film thickness of 2000 nm by using the mixed gas of SiH₄ and H₂, and an n type microcrystalline silicon semiconductor layer having a film thickness of 20 nm by using the mixed gas of SiH₄, H₂, and PH₃. Details of various conditions in the plasma CVD method are shown in Table 1.

**[ Table 1]**

| Plasma CVD conditions | | | | | | |
|---|---|---|---|---|---|---|
| | Layer | Substrate temperature (°C) | Gas flow rate (sccm) | Reaction pressure (Pa) | RF power (W) | Film thickness (nm) |
| a-Si film | p layer | 180 | SiH₄: 300 CH₄: 300 H₂: 2000 B₂H₆: 3 | 106 | 10 | 10 |
| | i layer | 200 | SiH₄: 300 H₂: 2000 | 106 | 20 | 300 |
| | n layer | 180 | SiH₄: 300 H₂: 2000 PH₃: 5 | 133 | 20 | 20 |
| microcrystalline Si film | p layer | 180 | SiH₄: 10 H₂: 2000 B₂H₆: 3 | 106 | 10 | 10 |
| | i layer | 200 | SiH₄: 100 H₂: 2000 | 133 | 20 | 2000 |
| | n layer | 200 | SiH₄: 10 H₂: 2000 PH₃: 5 | 133 | 20 | 20 |

Meanwhile, the photoelectric conversion layer 13 formed of the amorphous silicon semiconductor layer and the microcrystalline silicon semiconductor layer was patterned in the rectangle shape by applying the YAG layer from the light incident side onto a position located 50 µm away from the patterning position for the SnO₂ electrode 12. Nd:YAG laser having a wavelength of about 1.06 µm and energy density of 1×10⁵ W/cm² was used in this laser separation process.

Next, a ZnO film 14a having a thickness of 90 nm was formed on the microcrystalline silicon semiconductor layer by sputtering.

Next, the ZnO film 14a was patterned in the rectangle shape by applying the YAG laser from the back surface side onto a position located 50 µm away from the patterning position for the photoelectric conversion layer 13. Here, the width of each of the removed portions of the ZnO film 14a was set equal to 140 µm. The Nd:YAG laser having a wavelength of about 1.06 µm and energy density of 1×10⁵ W/cm² is used in this laser separation process.

Next, an Ag film 14b having a thickness of 200 nm was formed on the ZnO film 14a by sputtering.

Next, both of the separated photoelectric conversion layers 13 and the resultant Ag film 14b were patterned in the rectangle shape by applying the YAG laser from the light incident side. Here, the width of each of the removed portions of the Ag film 14b was set equal to 100 µm. The Nd:YAG laser having a wavelength of about 1.06 µm and energy density of 1×10⁵ W/cm² was used in this laser separation process.

Next, EVA 15 and a PET film 16 were sequentially disposed and then subjected to a heating treatment at 150°C for 30 minutes by using a lamination device. Consequently, the EVA 15 was cross-linked and stabilized.

Lastly, the solar cell module according to the example of the present invention was completed by attaching a terminal box and connecting extraction electrodes.

### <Conventional example>

The solar cell module 10 shown in Fig. 1 was fabricated as a conventional example. Similar processes to the above-described example were carried out in the conventional example except that, after the ZnO film 14a and the Ag film 14b were sequentially and continuously stacked on the photoelectric conversion layer 13, the YAG laser was applied from the light incident side onto a position located 100 µm away from the patterning position for the photoelectric conversion layer 13.

Consequently, in the first groove section 30, a portion of the separated ZnO film 14a was not covered with the Ag film 14b, and thus exposed.

### «Evaluation of Properties after Heat Annealing Process»

In order to compare the reliabilities between the solar cell module according to the example and the solar cell module according to the conventional example, properties of these modules were evaluated after carrying out a heat annealing process. To be more precise, a process to expose each of the modules in an atmosphere at a temperature of 200°C for 3 hours was carried out.

### <Results>

Results of the evaluation of the properties after the heat annealing process are as follows.

**[ Table 2]**

| Property changes by heat annealing process | | | | |
|---|---|---|---|---|
| | Open-circuit voltage | Short-circuit current | Fill factor | Conversion efficiency |
| Before heat annealing | 1.00 | 1.00 | 1.00 | 1.00 |
| Conventional example after heat annealing | 1.00 | 1.01 | 0.81 | 0.82 |
| Example after heat annealing | 1.00 | 1.01 | 1.00 | 1.01 |

After carrying out the heat annealing process, the conversion efficiency of the solar cell module according to the conventional example dropped by approximately 20% as compared to the case before the process.

On the other hand, no change was found in the conversion efficiency of the solar cell module according to the example even after carrying out the heat annealing process, and the module maintained a high power generation capacity.

To check the causes for the results shown on Table 2, the resistance of the ZnO film 14a in the solar cell module according to the conventional example after the heat annealing process was measured. The resistance value of the ZnO film 14a was found to be twice as high as before the heat annealing process. That is, it was confirmed that the moisture in the atmosphere deteriorated the ZnO film 14a.

As described above, the reason for decline in the conversion efficiency of the solar cell module according to the conventional example was confirmed to be attributable to the deterioration of the ZnO film 14a caused by the moisture that infiltrated from the first groove sections 30.

On the other hand, in the solar cell module according to the example, in the first groove section 30, the ZnO film 14a is in contact with the SnO₂ electrode 12 while covering the side wall of the photoelectric conversion layer 13. In addition, the Ag film 14b is in contact with the SnO₂ electrode 12 while covering the side wall of the ZnO film 14a. Further, in the first groove section 30, the Ag film 14b is in contact with the photoelectric conversion layer 13 while covering the side wall of the ZnO film 14a formed on the photoelectric conversion layer 13.

In this way, in the solar cell module according to the example, the Ag film 14b covers the ZnO film 14a, so that moisture does not come into contact with the ZnO film 14a. For this reason, the solar cell module according to the example could maintain a stable and high output.

In addition, ZnO has a significant advantage as the material of the transparent conductive film but it has not been possible to put ZnO into practical use due to its property that it is easily deteriorated by moisture. However, it is now apparent that ZnO can be sufficiently put into practical use by employing the configuration of the example.

It is to be noted that the entire contents of Japanese Patent Application No. 2006-324599 (filed on November 30, 2006) are incorporated herein by reference.

### Industrial Applicability

As described above, the solar cell module according to the present invention is able to maintain a high power generation capacity in spite of moisture infiltration and is therefore useful in photovoltaic power generation.

## Claims

1. A solar cell module comprising:
a transparent substrate;
a first electrode stacked on the transparent substrate;
a photoelectric conversion layer stacked on the first electrode;
a second electrode stacked on the photoelectric conversion layer; and
a groove section in which the second electrode is separated, wherein
the second electrode includes a transparent conductive film stacked on the photoelectric conversion layer and a metal film stacked on the transparent conductive film, and
in the groove section, the metal film is separated by a distance of a width smaller than a width that is a distance by which to separate the transparent conductive film.

2. The solar cell module according to claim 1,
wherein, in the groove section, the transparent conductive film is in contact with the first electrode while covering a side wall of the photoelectric conversion layer, and
in the groove section, the metal film is in contact with the first electrode while covering a side wall of the transparent conductive film.

3. The solar cell module according to claim 1,
wherein, in the groove section, the metal film is in contact with the photoelectric conversion layer while covering a side wall of the transparent conductive film.

4. A method of manufacturing a solar cell module provided with:
a transparent substrate; a first electrode stacked on the transparent substrate; a photoelectric conversion layer stacked on the first electrode; a transparent conductive film stacked on the photoelectric conversion layer; a metal film stacked on the transparent conductive film; and a groove section in which each of the photoelectric conversion layer, the transparent conductive film, and the metal film is separated, the method comprising:
a step A of removing a portion of the photoelectric conversion layer by irradiating the groove section with a laser beam;
a step B of stacking the transparent conductive film on the photoelectric conversion layer;
a step C of removing a portion of the transparent conductive film by irradiating the groove section with a laser beam;
a step D of stacking the metal film on the transparent conductive film; and
a step E of removing a portion of the metal film by irradiating the groove section with a laser beam,
wherein a width of the portion of the metal film removed in the step E is smaller than a width of the portion of the transparent conductive film removed in the step C.
